Europäisches Patentamt

European Patent Office

Office européen des brevets

(19)

(11) Publication number: **0 445 881 A1**

# (12) EUROPEAN PATENT APPLICATION

(21) Application number: **91200451.2**

(22) Date of filing: **04.03.91**

(51) Int. Cl.$^5$: **H05K 3/24, G02F 1/1343, H01L 31/18**

(30) Priority: **09.03.90 NL 9000545**

(43) Date of publication of application:
**11.09.91 Bulletin 91/37**

(84) Designated Contracting States:
**DE FR GB IT NL**

(71) Applicant: **N.V. Philips' Gloeilampenfabrieken**
**Groenewoudseweg 1**
**NL-5621 BA Eindhoven (NL)**

(72) Inventor: **Zegers, Johannes Gerardus**
**c/o INT. OCTROOIBUREAU B.V. Prof.**
**Holstlaan 6**
**NL-5656 AA Eindhoven (NL)**
Inventor: **Blezer, Hubert Willem**
**c/o INT. OCTROOIBUREAU B.V. Prof.**
**Holstlaan 6**
**NL-5656 AA Eindhoven (NL)**

(74) Representative: **Raap, Adriaan Yde et al**
**INTERNATIONAAL OCTROOIBUREAU B.V.**
**Prof. Holstlaan 6**
**NL-5656 AA Eindhoven (NL)**

(54) **Method of manufacturing conductor tracks.**

(57)    By making use of the difference in adhesion of a noble metal layer (3) to the substrate (1) on the one hand and to metal tracks (2) (for example ITO) on the other hand, it is possible to remove the noble metal layer (3) selectively by means of a lift-off technique so that a selective reinforcement of the tracks is realised in a self-registering way without any extra accurate photolithography step.

EP 0 445 881 A1

FIG.1a

FIG.1b

FIG.1c

## METHOD OF MANUFACTURING CONDUCTOR TRACKS

The invention relates to a method of manufacturing a device comprising a substrate having a pattern of transparent electrodes which are at least locally coated with a metal layer.

Such devices may form part of electro-optical display devices such as LCDs, but also other applications are feasible. In a liquid crystal display device glass-deposited indium tin oxide (ITO) electrodes defining the pixels are generally used.

A method of the type described above in which the indium tin oxide tracks in a liquid crystal display device are coated with extra metal layers is described in US-P 4,543,573. Notably in this method double layers of chromium and nickel (or gold) are provided on the ITO tracks to reinforce the tracks and to decrease the resistance. Although the opening paragraph states the possibility of several metal layers on the indium tin oxide, this possibility is rejected notably for the noble metals because they do not adhere satisfactorily to the indium tin oxide tracks and thus get easily detached.

It is one of the objects of the invention to provide a method in which in contra distinction to the method described in US-P 4,543,573, a layer of noble metal adheres satisfactorily to the indium tin oxide. It is another object to provide a method which is simpler and hence less expensive because it is sufficient to use simpler photolithography (fewer steps).

The invention is based on the recognition that this can be achieved by giving the device a suitable intermediate treatment.

To this end a method according to the invention is characterized in that after the transparent electrodes have been provided in patterns at the area of a double layer to be formed of the electrode material and a noble metal or seminoble metal, the noble metal or seminoble metal is provided on the electrode as well as on the substrate and is subsequently removed from the substrate after it has been immersed in acid.

Since this method employs the differences in adhesion of the metal to the substrate and the electrodes, the method is self-registering.

Moreover, as compared with the method as described in US-P 4,543,573, this method requires one photolithography step less.

Immersion in acid appears to be essential to ensure both the adhesion of the (semi)noble metal, particularly gold on the electrodes and to deteriorate the adhesion of, for example gold on glass. The (semi)noble metal starts to loosen from the substrate and can be removed, for example by means of a mechanical treatment (spraying water, brushing, vibrating).

A hydrochloric acid solution is preferably chosen as an acid, but other acids are alternatively possible.

The finished substrate may form a liquid crystal cell together with another substrate in generally known manner, with a liquid crystal material between the two substrates and, if necessary, polarizers and/or mirrors, as well as the required provisions for driving, illumination etc.

These and other aspects of the invention will now be described in greater detail with reference to the drawing and an embodiment.

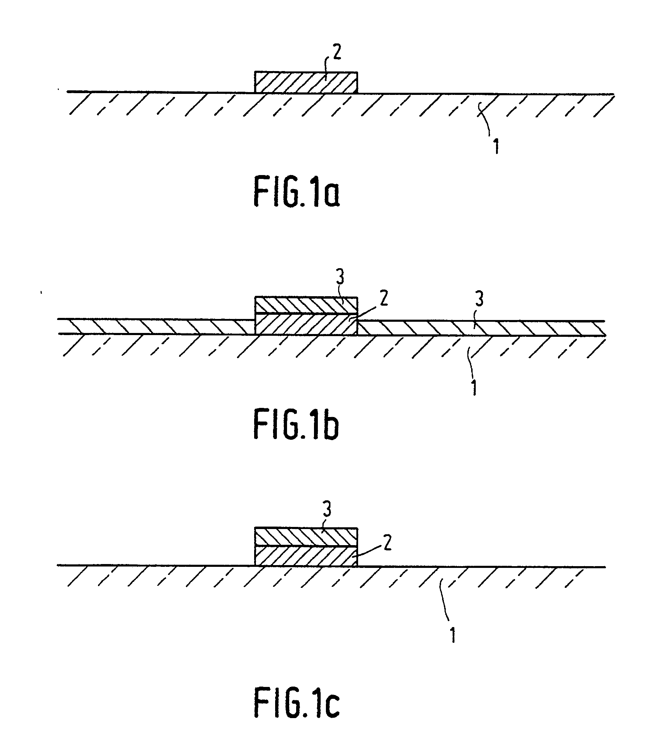

Fig. 1 shows diagrammatically a number of steps of a method according to the invention.

The starting material is a substrate 1, for example, glass (or quartz) (Fig. 1a) on which transparent electrodes 2, in this example of indium tin oxide, are provided in the form of patterns.

To protect indium tin oxide electrodes 2 which need not be provided with the conducting layer, they may be shielded with a coarse mask. Subsequently, a layer 3 of satisfactorily conducting metal, for example, gold is deposited on the entire device by means of sputtering or vapour deposition (Fig. 1b).

Subsequently, the entire device is immersed in an acid bath, for example, in a 10% hydrochloric acid bath for 2 minutes. It appears that the adhesion of the gold to the glass considerably deteriorates thereby, whereas the gold-ITO adhesion is not affected. The gold may even begin to loosen from the substrate. In a subsequent step the gold residues can be removed in a simple manner by a mechanical treatment such as brushing, vibrating, or spraying water. Instead of gold other noble metals such as silver and copper may be used alternatively, while quartz or another suitable material may be alternatively chosen for the substrate 1.

## Claims

1. A method of manufacturing a device comprising a substrate having a pattern of transparent electrodes which are at least locally coated with a metal layer, characterized in that after the transparent electrodes have been provided in patterns at the area of a double layer to be formed of the electrode material and a noble metal or a seminoble metal, the noble metal or seminoble metal is provided on the electrode as well as on the substrate and is subsequently removed from the substrate after it has been immersed in acid.

2. A method as claimed in Claim 1, characterized in that the transparent electrodes comprise indium tin oxide and in that gold is used as a noble metal.

3. A method as claimed in Claim 1 or 2, characterized in that a glass substrate or a quartz substrate is used.

4. A method as claimed in any one of Claims 1 to 3, characterized in that the noble metal is removed from the substrate by means of a mechanical treatment.

5. A liquid crystal display device comprising two substrates between which a liquid crystal material is provided, characterized in that at least one of the substrates is manufactured by means of a method as claimed in any one of Claims 1 to 4.

FIG.1a

FIG.1b

FIG.1c

| | European Patent Office | EUROPEAN SEARCH REPORT | Application Number |
|---|---|---|---|

EP    91 20 0451

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| A | EP-A-265110 (ANDUS CORP.)<br>* column 2, lines 13 - 46 *<br>* column 5, lines 7 - 20 *<br>--- | 1, 2, 5 | H05K3/24<br>G02F1/1343<br>H01L31/18 |
| A | US-A-4543573 (FUYAMA ET AL.)<br>* column 2, lines 12 - 41 *<br>* column 3, lines 56 - 58 *<br>--- | 1-3, 5 | |
| A | US-A-4582722 (HERRON ET AL.)<br>* abstract *<br>--- | 1, 2, 4 | |
| A | EP-A-89559 (IBM)<br>* page 5, lines 17 - 25 *<br>* page 7, lines 20 - 35 *<br>----- | 1, 3, 4 | |
| | | | TECHNICAL FIELDS SEARCHED (Int. Cl.5 )<br><br>H05K<br>G02F<br>C23F<br>H01L |

| The present search report has been drawn up for all claims | | |
|---|---|---|
| Place of search<br>THE HAGUE | Date of completion of the search<br>03 JUNE 1991 | Examiner<br>MES L.A. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)